# EUROPÄISCHE PATENTANMELDUNG

(11) **EP 1 262 430 A2**
(43) Veröffentlichungstag der Anmeldung: **04.12.2002**
(21) Anmeldenummer: 02011231.4
(22) Anmeldetag: 22.05.2002
(51) Int. Cl.: B65G 47/52

(54) **Transporteinrichtung für flache Gegenstände**

(30) Priorität: 01.06.2001 DE 10127778
(71) Anmelder: Gebr. Schmid GmbH & Co., D-72250 Freudenstadt (DE)
(72) Erfinder: Schmid, Dieter C., 72250 Freudenstadt (DE)
(74) Vertreter: Renger, Florian (DE)

(57) **Zusammenfassung**

Eine Transporteinrichtung für Leiterplatten (21) in der Elektronikindustrie weist eine Zuführeinrichtung (14), eine Aufnahmeeinrichtung (12) und einen Aufnahmebehälter (16) für die Leiterplatten (21) auf. Die Zuführeinrichtung führt eine Leiterplatte dem Aufnahmebehälter zu. Durch dessen Boden (17) bzw. entsprechende Ausnehmungen (18) darin fährt die Aufnahmeeinrichtung (14) über den Aufnahmebehälter, übernimmt die Leiterplatte (21) und senkt sie durch Herunterfahren auf dem Boden ab. Anschließend kann der Aufnahmebehälter (16) samt Leiterplatte (21) weitertransportiert oder zwischengelagert werden. Eine Zwischenlagerung der Leiterplatten kann in den Aufnahmebehältern in einem Magazin (26) erfolgen.

## Beschreibung

### Anwendungsgebiet und Stand der Technik

Die Erfindung betrifft eine Transporteinrichtung für flache Gegenstände. Dies sind insbesondere Leiterplatten oder ähnliche dünne, sehr empfindliche Substrate in der Elektronik- oder optischen Industrie.

Beispielsweise bei Leiterplatten in der Elektronikindustrie, die Dicken von weit weniger als einen Millimeter aufweisen, besteht das Problem, diese zu transportieren bzw. im Herstellungs- und Bearbeitungsverfahren zu verteilen und somit auch zwischenzulagern. Dabei muß vor allem auf die besonders große mechanische Empfindlichkeit der Gegenstände bzw. Leiterplatten Rücksicht genommen werden.

### Aufgabe und Lösung

Der Erfindung liegt die Aufgabe zugrunde, eine eingangs erwähnte Transporteinrichtung zu schaffen, mit der flache Gegenstände allgemein und insbesondere empfindliche Gegenstände, beispielsweise Leiterplatten, transportiert und abgelegt bzw. zwischengespeichert werden können.

Diese Aufgabe wird gelöst durch eine Transporteinrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß sind eine Gegenstands-Aufnahmeeinrichtung, ein Gegenstands-Aufnahmebehälter und eine Gegenstands-Zuführeinrichtung vorgesehen. Die Zuführeinrichtung führt dabei einen Gegenstand dem Aufnahmebehälter zu bzw. an diesen heran. Die Aufnahmeeinrichtung nimmt den Gegenstand auf. Dabei fährt bzw. läuft sie durch den Aufnahmebehälter hindurch, um den Gegenstand aufzunehmen bzw. zu fassen. Danach bringt sie ihn in den Aufnahmebehälter bzw. eine Aufnahmeposition in dem Behälter.

Bei dem Einbringen des Gegenstandes in den Aufnahmebehälter fährt die Aufnahmeeinrichtung aus dem Aufnahmebehälter heraus. Dabei legt sie den Gegenstand in dem Aufnahmebehälter ab. Durch das erfindungsgemäße Bewegen der Aufnahmeeinrichtung durch den Aufnahmebehälter hindurch kann der Gegenstand besonders schonend abgelegt und positioniert bewegt werden. Es kann vorteilhaft auch ein Arbeitsschritt des Entfernens der Aufnahmeeinrichtung nach dem Ablegen eingespart werden. Des weiteren ist die Anfälligkeit der Einrichtung gegen Fehler geringer, wenn sich die Aufnahmeeinrichtung bei der Übergabe des Gegenstandes in den Aufnahmebehälter bereits in dessen Bereich befindet.

Bevorzugt bewegt sich die Aufnahmeeinrichtung durch den Boden des Aufnahmebehälters. Besonders bevorzugt verläuft diese Bewegungsrichtung im wesentlichen senkrecht bzw. nach unten, so dass auf den Gegenstand lediglich Bewegungskräfte entlang einer Achse wirken.

Der Aufnahmebehälter ist mit Vorteil flach ausgebildet, beispielsweise nach Art eines Tabletts mit einem zumindest bereichsweise seitlich hochstehenden Rand oder dergleichen. In seinem Boden weist der Aufnahmebehälter Ausnehmungen auf, die entsprechend der Aufnahmeeinrichtung geformt sind bzw. deren Durchgreifen durch den Boden erlauben. Diese Ausnehmungen sind vorteilhaft so ausgebildet, dass dazwischen ausreichend Platz für eine sichere und flächige Auflage der Gegenstand in dem Behälterboden gewährleistet ist.

Es ist auch möglich, die Aufnahmebehälter derart auszubilden, dass sie ineinander stapelbar sind. Dieses Stapeln sollte jedoch dadurch gekennzeichnet sein, dass ein in einem Behälter befindlicher Gegenstand nicht beeinträchtigt wird. Die Behälter sollten also nur aufeinander aufliegen und nicht auf einem darin befindlichen Gegenstand.

Gemäß einer bevorzugten Ausführungsmöglichkeit sind die Zuführeinrichtung und/oder die Aufnahmeeinrichtung rotierend ausgebildet, um sowohl einen kontinuierlichen als auch sicheren Transport der Gegenstände zu gewährleisten. Bevorzugt erfolgt dies mit Bändern und/oder Rollen, auf denen die Gegenstände aufliegen, also nach Art von Rollbahnen oder dergleichen.

Die Zuführeinrichtung kann mehrteilig ausgebildet sein bzw. mit der Aufnahmeeinrichtung einen mehrteiligen Verbund bilden. Ein Teil führt dabei die Gegenstände heran in den Bereich des Aufnahmebehälters bzw. in dessen Nähe. Dort wird der Gegenstand an einen anderen Teil übergeben, insbesondere an die Aufnahmeeinrichtung, um den Gegenstand in den Aufnahmebehälter einzubringen. Die Übergabe kann dabei kontinuierlich und ohne Lageänderung des Gegenstandes erfolgen. Der Ausdruck Lageänderung ist hier so zu verstehen, dass der Gegenstand möglichst nur linear bewegt wird ohne um waagrechte Körperachsen gedreht zu werden. Hierbei ist zu beachten, dass eine möglichst geringe Bewegung der Gegenstände dessen mechanische Belastungen gering hält, was anzustreben ist.

Es ist von Vorteil, wenn durch die Zuführeinrichtung bzw. die Aufnahmeeinrichtung der Gegenstand flächig gestützt wird bzw. die Unterstützung oder Auflage des Gegenstandes sich auf mehrere größere Flächen verteilt. Dadurch können Punktbelastungen bei empfindlichen Gegenständen vermieden werden.

Die Aufnahmeeinrichtung kann Rollen und/oder Bänder aufweisen, die angehoben werden können. Diese können von unten durch den Boden eines Aufnahmebehälters fahren und den Gegenstand von der Zuführeinrichtung übernehmen. Während diese Übernahme beispielsweise durch eine horizontale lineare Bewegung erfolgen kann, kann das Ablegen des Gegenstandes durch eine Bewegung der Aufnahmeeinrichtung relativ zu dem Aufnahmebehälter in senkrechter Richtung erfolgen. Besonders vorteilhaft ist es möglich, den Aufnahmebehälter von der insofern unbeweglich gehaltenen Aufnahmeeinrichtung nach oben abzuheben und dadurch den Gegenstand zu übernehmen.

Ein Bewegen des Aufnahmebehälters ist mit Vorteil durch Transportmittel oder dergleichen in die Aufnahmeposition hinein oder von dieser weg möglich. Diese Transportmittel können bei einer Ausführung der Erfindung rotierend sein, beispielsweise ein Rollenband aufweisen. Mit besonderem Vorteil entsprechen diese Transportmittel vom Funktionsprinzip her der Aufnahmeeinrichtung oder Zuführeinrichtung. Zum platzsparenden Aufbau der Transporteinrichtung ist es möglich, die Aufnahmeeinrichtung durch die Transportmittel für den Aufnahmebehälter greifen zu lassen, wenn diese einen Gegenstand aufnimmt. In diesem Fall fährt die Aufnahmeeinrichtung sowohl durch die Transportmittel als auch durch den Aufnahmebehälter, was ohne Probleme möglich ist.

In weiterer Ausgestaltung der Erfindung können Greifmittel vorgesehen sein, die zum Erfassen eines Behälters und Bewegen desselben ausgebildet sind, insbesondere aus der Aufnahmeposition heraus. In Verbindung mit den oben beschriebenen Transportmitteln kann so beispielsweise ein Behälter mit den Transportmitteln in die Aufnahmeposition hinein und mit den Greifmitteln aus der Aufnahmeposition heraus bewegt werden. Dies hat den Vorteil, dass ein kontinuierliches Befüllen von Aufnahmebehältern mit Gegenständen möglich ist, da die Transportmittel schnell wieder frei sind. Die Greifmittel können dabei mit Vorteil derart ausgebildet sein, dass sie freie Bewegungen im Raum ausführen können. Bevorzugt wird hier beispielsweise ein Gelenkarm. Mit solchen Greifmitteln ist es möglich, einen befüllten Aufnahmebehälter im wesentlichen frei weiterzubewegen.

Des weiteren kann ein Magazin oder dergleichen vorgesehen sein, in dem Aufnahmebehälter, insbesondere mit Gegenständen darin, gelagert oder aufbewahrt werden können. Das Magazin ist dabei bevorzugt derart ausgebildet, dass die Aufnahmebehälter einzeln und in beliebiger Reihenfolge einbringbar und entnehmbar sind. Durch eine solche unabhängige Verfahrensweise kann ein Magazin als Zwischenlager sowie als Verteilstation verwendet werden. Dies ist insbesondere dann von Vorteil, wenn sich die Gegenstände voneinander in mancher Hinsicht, sei es Aufbau oder Zweckbestimmung, voneinander unterscheiden. Ebenso kann ein solches Magazin für einen Zwischenschritt in einer Fertigung verwendet werden, beispielsweise als Trockenstation, wenn Leiterplatten zwischen zwei Verarbeitungsschritten oder vor einer Weiterverarbeitung eine bestimmte Ablagezeit benötigen.

Eine Ausführungsmöglichkeit der Erfindung kann dabei vorsehen, dass das Magazin Schubfächer aufweist und die Aufnahmebehälter übereinander angeordnet sind. Besonders bei tablettartigen Aufnahmebehältern kann so eine große Stapeldichte erzielt werden.

Die oben beschriebene Greifmittel können dazu ausgebildet sein, Aufnahmebehälter dem Magazin zuzuführen bzw. sie auch daraus zu entnehmen. Alternativ dazu können dem Magazin zweite Greifmittel zugeordnet sein, mit denen die Aufnahmebehälter entnommen werden können. Diese Greifmittel können im wesentlichen gleich ausgebildet sein und das Verfahren des Herausnehmens der Aufnahmebehälter in umgekehrter Reihenfolge wie das Einbringen ablaufen. Auf diese Weise ist es beispielsweise möglich, von einer Seite her Aufnahmebehälter in das Magazin einzubringen und sie von einer anderen Seite her wieder zu entnehmen. Damit kann schneller gearbeitet werden.

Des weiteren können eine zweite Aufnahmeeinrichtung und eine zweite Gegenstands-Zuführeinrichtung bzw. -Abführeinrichtung vorgesehen sein. Die zweite Aufnahmeeinrichtung kann dabei einen Gegenstand aus dem Aufnahmebehälter entnehmen und der zweiten Zuführ- bzw. Abführeinrichtung übergeben. Hier ist es mit Vorteil möglich, die zweite Aufnahmeeinrichtung und die zweite Zuführeinrichtung ähnlich oder gleich auszubilden wie die eingangs erwähnten ersten Einrichtungen dieser Art. An die zweite Zuführeinrichtung, die in diesem Fall sinngemäß mehr die Funktion einer Abführeinrichtung übernimmt, kann sich ein verfahrensmäßiger Weitertransport der Gegenstände anschließen.

Die vorstehenden und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

Ausführungsbeispiele der Erfindung sind in den Zeichnungen dargestellt und werden im folgenden näher erläutert. In den Zeichnungen zeigen:
- Fig. 1: den Aufbau einer Zuführeinrichtung, Aufnahmeeinrichtung sowie Aufnahmebehälter und Verfahrensablauf,
- Fig. 2: einen Aufbau ähnlich Fig. 1 zum Abtransport von Gegenständen,
- Fig. 3: eine Variation nach Fig. 2 mit Rollen anstatt Bändern,
- Fig. 4: eine Frontansicht eines Magazins für Behälter und
- Fig. 5: eine Draufsicht auf eine Transporteinrichtung mit Zuführung, Abführung und Magazin.

### Detaillierte Beschreibung der Ausführungsbeispiele

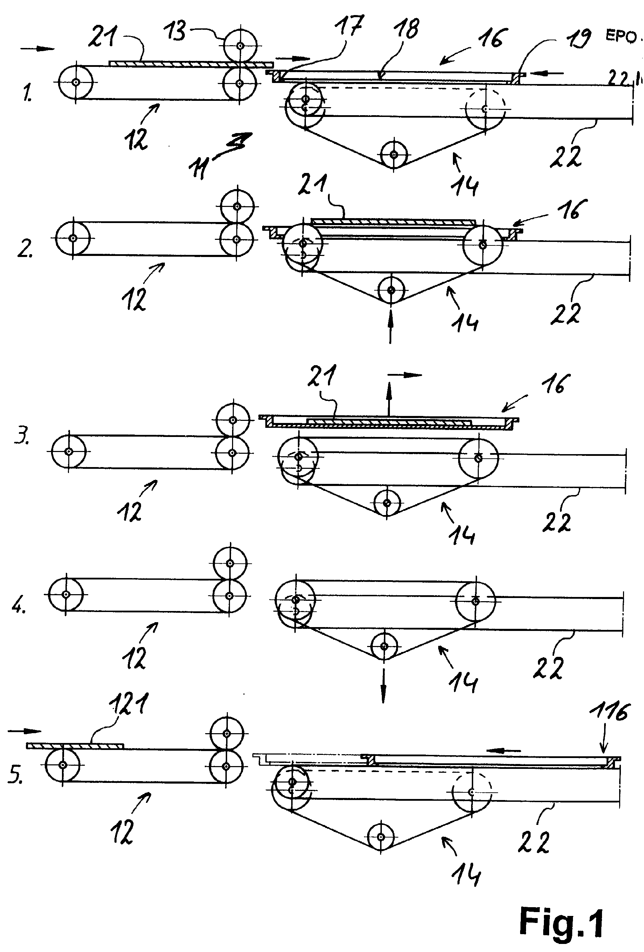

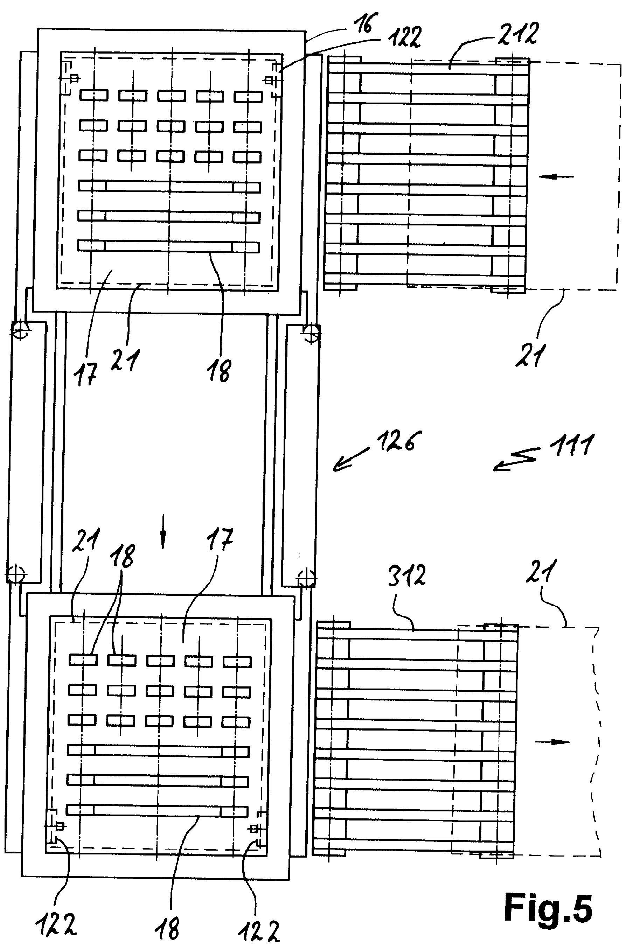

Fig. 1 zeigt eine Transporteinrichtung 11 mit einer Gegenstands-Zuführeinrichtung 12, einer Gegenstands-Aufnahmeeinrichtung 14 und einem Gegenstands-Aufnahmebehälter 16. Dabei ist die Zuführeinrichtung 12 als Rollenband mit einem nicht dargestellten Antrieb sowie einem Andruckrad 13 ausgebildet. Die Aufnahmeeinrichtung 14 ist ebenfalls als Rollenband mit einem nicht dargestellten Antrieb ausgebildet. Der Aufnahmebehälter 16 ist nach Art eines flachen Tabletts ausgebildet. Er weist einen Boden 17 mit Ausnehmungen 18 darin auf. Die Form der Ausnehmungen 18 hängt im wesentlichen von der Aufnahmeeinrichtung 14 ab und ist beispielhaft aus der Fig. 5 zu entnehmen.

Des weiteren weist der Aufnahmebehälter 16 einen flachen Rand 19 auf. Dieser schützt auf dem Boden 17 aufliegende Gegenstände bei direkt aufeinander gestapelten Aufnahmebehältern. Bei einer Ausführung der Erfindung kann der Rand 19 in der Art stufig ausgebildet sein, dass sich die Behälter 16 ineinander stapeln lassen und dennoch ein darin befindlicher Gegenstand geschützt untergebracht ist.

Als Gegenstand ist hier eine Leiterplatte 21 dargestellt, die extrem dünn sein kann, beispielsweise mit einer Dicke von 35 µm. Wegen dieser sehr geringen Dicke ist sie mechanisch sehr anfällig und sollte deswegen in den Aufnahmebehältern 16 zwischengelagert oder transportiert werden.

Wie in der obersten Darstellung zu erkennen ist, wird die Leiterplatte 21 von der Zuführeinrichtung 12 in Pfeilrichtung nach rechts transportiert. Von rechts wird auf Transportmitteln in Form eines weiteren Rollenbandes 22 ein Aufnahmebehälter 16 herangeführt. Der Aufnahmebehälter 16 wird über der Aufnahmeeinrichtung 14 platziert. Anschließend wird die Aufnahmeeinrichtung 14 angehoben auf eine Höhe, die mit derjenigen der Zuführeinrichtung 12 übereinstimmt. Dies ist in der zweiten Darstellung zu erkennen. Hier ist zu erkennen, wie bereits die Leiterplatte 21 von der Zuführeinrichtung 12 zu der Aufnahmeeinrichtung 14 übergeben wurde und auf dieser oberhalb des Aufnahmebehälters 16 aufliegt.

In der dritten Darstellung ist zu erkennen, wie der Aufnahmebehälter 16 angehoben und entfernt wird. Bei dem Anheben des Aufnahmebehälters 16 erhebt sich dieser über die Aufnahmeeinrichtung 14. Dies entspricht im wesentlichen der gleichen Bewegung, wie wenn sich die Aufnahmeeinrichtung 14 nach unten wieder aus dem Aufnahmebehälter, durch den sie sich in der zweiten Darstellung erhoben hat, zurückzieht. Bei diesem Vorgang wird die Leiterplatte 21 von der Aufnahmeeinrichtung 14 an den Aufnahmebehälter 16 übergeben. Anschließend liegt sie auf dem Boden 17 auf und ist sicher verwahrt. Der befüllte Aufnahmebehälter 16 kann dann weiter transportiert werden. Das Anheben desselben erfolgt mit nicht dargestellten Greifmitteln, auf die später genauer eingegangen wird.

In der vierten Darstellung ist zu erkennen, wie die Aufnahmeeinrichtung 14 wieder nach unten unterhalb des Rollenbandes 22 bewegt wird.

Abschließend wird, wie in der fünften Darstellung zu sehen, eine weitere Leiterplatte 121 auf der Zuführeinrichtung 12 herangeführt. Ebenso wird mittels des Rollenbandes 22 ein weiterer Aufnahmebehälter 16 von rechts herangeführt und in die strichpunktiert dargestellte Position über der Aufnahmeeinrichtung 14 gebracht. Daran anschließend erfolgt wieder die Übergabe der Leiterplatte 121 gemäß der ersten Darstellung in Fig. 1.

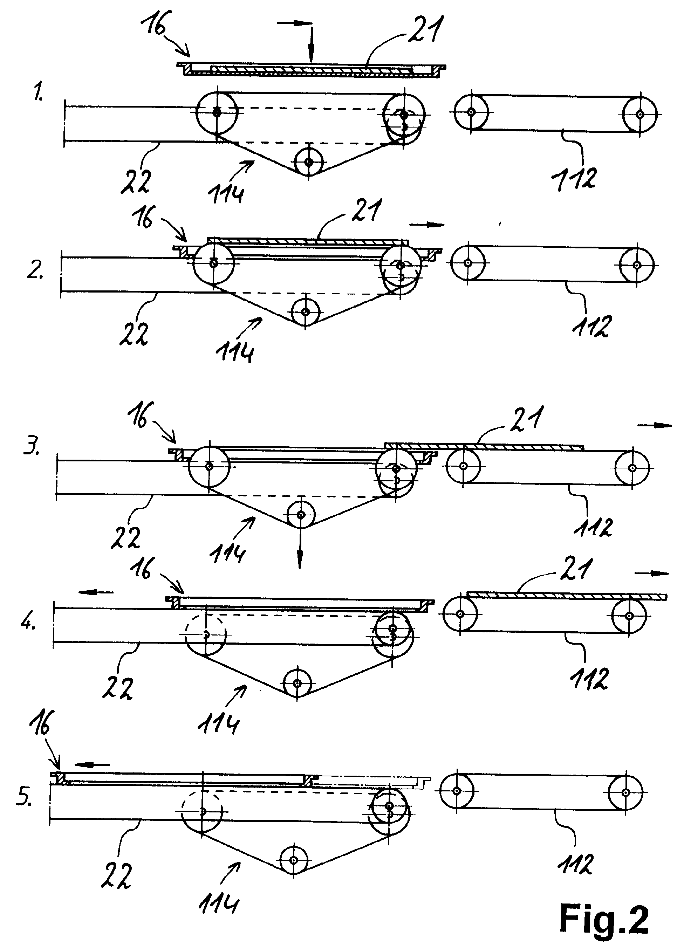

Nachdem in Fig. 1 die Aufnahme bzw. die Übergabe einer Leiterplatte in einen Aufnahmebehälter dargestellt worden ist, ist in Fig. 2 das Ausbringen der Leiterplatte aus dem Aufnahmebehälter gezeigt. In der ersten Darstellung ist zu sehen, wie ein mit einer Leiterplatte 21 befüllter Aufnahmebehälter 16 von nicht dargestellten Greifmitteln oder dergleichen herangeführt und abgesetzt wird. Wie in der zweiten Darstellung zu erkennen, wird der Aufnahmebehälter dabei über eine Aufnahmeeinrichtung 114 derart platziert und abgesetzt, dass diese der zweiten Darstellung der Fig. 1 entsprechend beim Absetzen des Behälters durch die Ausnehmungen 18 in dessen Boden 17 in ihn hinein einfährt. Dabei wird, wie in der zweiten Darstellung zu erkennen, die Leiterplatte 21 vom Boden 17 abgehoben und liegt nunmehr auf der Aufnahmeeinrichtung 114 über dem Aufnahmebehälter 16. Mit der Aufnahmeeinrichtung 114 in Form eines Rollenbandes wird die Leiterplatte 21 in entsprechender Verfahrensweise nach Fig. 1 der Zuführeinrichtung 112 übergeben bzw. nach rechts gefahren, siehe die dritte Darstellung in Fig. 2.

Nach der kompletten Übergabe wird gemäß der vierten Darstellung die Aufnahmeeinrichtung 114 wieder nach unten aus dem Aufnahmebehälter 16 heraus gefahren. Danach wird die Leiterplatte 21 nach rechts abtransportiert mittels der Zuführeinrichtung 112 und einem weiteren Verfahrensschritt zugeführt. Der leere Aufnahmebehälter 16 wird mittels des Rollenbandes 122 nach links wegbewegt, siehe auch die fünfte Darstellung. Anschließend kann ein neuer Entnahmevorgang gemäß der ersten Darstellung beginnen.

Bei den Fig. 1 und 2 ist zu beachten, dass die Bewegung der Aufnahmebehälter auch umgekehrt erfolgen könnte. So ist es möglich, bei dem Einlagern einer Leiterplatte n einen Aufnahmebehälter den Aufnahmebehälter mittels der Greifmittel heranzuführen. Nach dem Beladen mit der Leiterplatte kann der Aufnahmebehälter mittels des Rollenbandes abtransportiert werden. Dazu ist jedoch erforderlich, dass zuerst die Aufnahmeeinrichtung mit der darauf befindlichen Leiterplatte abgesenkt wird, wobei beim Absenken die Leiterplatte auf dem Boden des Aufnahmebehälters abgelegt wird.

Entsprechend kann in Fig. 2 verfahren werden. Hier würde der Abtransport des Aufnahmebehälters samt Leiterplatte mittels des Rollenbandes 122 erfolgen. Eine nach oben durch den Boden 17 des Aufnahmebehälters 16 fahrende Aufnahmeeinrichtung 114 hebt die Leiterplatte 21 von dem Boden 17 ab. Anschließend wird die Leiterplatte 21, wie bereits in Fig. 2 dargestellt, an die Zuführeinrichtung 112 übergeben. Abschließend wird der Aufnahmebehälter mittels nicht dargestellter Greifmittel entfernt.

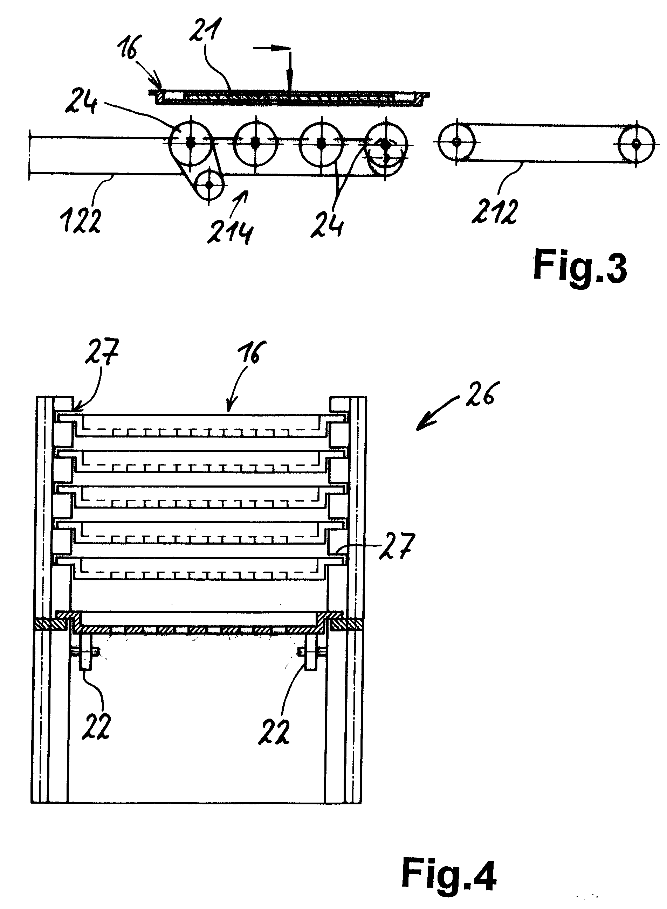

In Fig. 3 ist dargestellt, wie eine Aufnahmeeinrichtung 214 entsprechend der ersten Darstellung der Fig. 2 alternativ mit Rollen anstatt mit Bändern aufgebaut sein kann. Es ist zu erkennen, dass vier Rollen 24 vorhanden sind, die sich über eine ähnliche Länge wie das Rollenband der Aufnahmeeinrichtung 14 und 114 gemäß Fig. 1 und 2 erstrecken. Dargestellt ist zwar lediglich ein Antrieb für die linke Rolle. Ebenso können auch verschiedene oder alle Rollen 24 angetrieben sein.

Bei dem Boden 117 des Aufnahmebehälters 116 ist zu erkennen, wie die Ausnehmungen 118 lediglich den Rollen entsprechend ausgebildet sind. Sie erstrecken sich nicht größtenteils über die Länge des Bodens gemäß Fig. 1 oder 2. Sie weisen lediglich die Ausschnittgröße auf, die für das Durchgreifen der Rollen 24 notwendig ist.

In Fig. 4 ist in Vorderansicht ein Magazin 26 dargestellt. Darin können in Fächer 27 Aufnahmebehälter 16 aufbewahrt werden. In die Fächer 27 können die Aufnahmebehälter 16 mit nicht dargestellten Greifmitteln oder dergleichen eingebracht werden. Dargestellt sind fünf Aufnahmebehälter 16, die sich in Fächern 27 befinden.

Zuunterst ist in dem Magazin 26 ein Aufnahmebehälter 16 im Schnitt dargestellt, der mittels eines durchlaufenden Rollenbandes 22, von dem im wesentlichen nur die Rollen dargestellt sind, durch das Magazin 26 hindurch bewegt werden kann. Mit dem Rollenband 22 ist ein Durchlauf von Aufnahmebehältern 16 durch das Magazin 26 hindurch möglich, ohne einen Aufnahmebehälter in ein Fach einzubringen. Es ist selbstverständlich, dass ein solches Magazin 26 auch anders ausgebildet werden kann. Für den Fachmann auf diesem Gebiet ist offensichtlich, dass hier sämtliche Möglichkeiten der Aufbewahrung bzw. Lagerhaltung solcher Aufnahmebehälter 16 offen stehen. Dabei ist zu beachten, dass die Aufnahmebehälter 16 stets waagerecht liegen sollten, um die sich darin befindlichen Leiterplatten 21 nicht zu beschädigen.

In Fig. 5 ist in Draufsicht eine komplette Transporteinrichtung 111 dargestellt. Sie weist oben rechts eine Zuführeinrichtung 212 auf zum Zuführen von Leiterplatten 21. Daran schließt sich ein Rollenband 122 an, das sich entlang der gesamten Transporteinrichtung 111 von oben nach unten erstreckt. Darauf liegt in Fig. 5 oben ein Aufnahmebehälter 16 sowie in Fig. 5 unten ebenfalls ein Aufnahmebehälter 16 auf. Dazwischen befindet sich ein Magazin 126, das lediglich schematisch dargestellt ist. Es kann demjenigen in Fig. 4 entsprechen. Auf dem Rollenband 122 können die Aufnahmebehälter 16 zwischen den beiden dargestellten Positionen verfahren. Aus den dargestellten Positionen können sie mittels nicht dargestellter Greifmittel entfernt oder aber in das Magazin 126 eingebracht werden.

Nicht dargestellt sind in Fig. 5 Aufnahmeeinrichtungen, die denen in den Fig. 1 bis 3 entsprechen. Es ist jedoch durch die Anordnung der Ausnehmungen 18 im Boden 17 der Aufnahmebehälter 16 ersichtlich, dass diese vorhanden sind. Einerseits sind für die Aufnahmeeinrichtungen Ausführungen möglich, bei denen es sich um Riemen- oder Rollenbänder handelt. Für diese sind die Ausnehmungen 18 als lange Schlitze ausgebildet. Ebenso können mehrere Rollen gemäß Fig. 3 vorgesehen werden, für die die Ausnehmungen 18 nach Art hintereinander angeordneter kurzer Schlitze ausgebildet sind.

Es ist zu erkennen, wie in Fig. 5 rechts oben eine Leiterplatte 21 mittels der Zuführeinrichtung 212 angeliefert wird. Mit der Aufnahmeeinrichtung unterhalb des Aufnahmebehälters 16 in Fig. 5 oben erfolgt die Übergabe und das Einbringen in den Aufnahmebehälter 16. Anschließend kann der Aufnahmebehälter 16 entweder mit dem Rollenband 122 oder nicht dargestellten anderen Transportmöglichkeiten abtransportiert oder in das Magazin 126 eingelagert werden.

Auf dieselbe Art und Weise kann ein mit einer Leiterplatte versehener Aufnahmebehälter 16 in die in Fig. 5 unten dargestellte Position gebracht werden. Über eine Aufnahmeeinrichtung erfolgt analog wieder die Übergabe an die Zuführeinrichtung 312, mittels der die Leiterplatte 21 abtransportiert wird. Die Übergabe von der Zuführeinrichtung zu einer Aufnahmeeinrichtung bzw. in den Aufnahmebehälter 16 erfolgt wie oben zu den Fig. 1 und 2 beschrieben.

Bei einer weiteren Ausführung eines Magazins ist es möglich, dieses mit seitlichen Greifeinrichtungen nach Art einer Klammer oder dergleichen auszustatten. In diesem Fall kann ein Aufnahmebehälter ähnlich wie in Fig. 4 und Fig. 5 dargestellt in das Magazin einfahren und mittels der Greifer in das Magazin bzw. ein Fach eingebracht werden. Ebenso kann das Ausbringen erfolgen.

Des weiteren ist es bei einer Transporteinrichtung gemäß Fig. 5 möglich, die Zuführeinrichtungen 212 und 312 mit einer anderen Richtung als dargestellt anzuordnen. So kann eine Zuführeinrichtung auch in Richtung des Rollenbandes 122 verlaufen.

## Patentansprüche

1. Transporteinrichtung für flache Gegenstände, insbesondere Leiterplatten (21) in der Elektronikindustrie, mit:
- einer Gegenstands-Zuführeinrichtung (12),
- einem Gegenstands-Aufnahmebehälter (16) und
- einer Gegenstands-Aufnahmeeinrichtung (14),
wobei die Gegenstands-Zuführeinrichtung (12) einen Gegenstand (21) einem Gegenstands-Aufnahmebehälter (16) zuführt, die Gegenstands-Aufnahmeeinrichtung (14) durch den Gegenstands-Aufnahmebehälter (16) hindurch verläuft und den Gegenstand (21) aufnimmt und in seine Aufnahmeposition in dem Gegenstands-Aufnahmebehälter (16) bringt, wobei sich die Gegenstands-Aufnahmeeinrichtung (14) beim Einbringen des Gegenstands (21) wieder aus dem Gegenstands-Aufnahmebehälter (16) zurückzieht und dabei den Gegenstand (21) ablegt.

2. Transporteinrichtung nach Anspruch 1, **dadurch gekennzeichnet, dass** sich die Aufnahmeeinrichtung (14) durch den Boden (17) des Aufnahmebehälters (16) bewegt.

3. Transporteinrichtung nach Anspruch 1 oder 2, **dadurch gekennzeichnet, dass** der Aufnahmebehälter (16) flach ist, insbesondere nach Art eines Tabletts ausgebildet ist, und Ausnehmungen (18) in seinem Boden (17) entsprechend der Aufnahmeeinrichtung (14) aufweist.

4. Transporteinrichtung nach einem der vorhergehenden Ansprüche, **dadurch gekennzeichnet, dass** die Zuführeinrichtung (12) und/oder die Aufnahmeeinrichtung (14) rotierend ausgebildet sind, vorzugsweise mit Bändern und/oder Rollen (24) für die Gegenstände (21).

5. Transporteinrichtung nach einem der vorhergehenden Ansprüche, **dadurch gekennzeichnet, dass** die Zuführeinrichtung (12) mehrteilig ist, wobei ein Teil die Gegenstände (21) heranführt und an einen anderen Teil für das Einbringen in den Aufnahmebehälter (16) übergibt, wobei vorzugsweise die Übergabe kontinuierlich und ohne Lageänderung des Gegenstandes (21) erfolgt.

6. Transporteinrichtung nach einem der vorhergehenden Ansprüche, **dadurch gekennzeichnet, dass** die Zuführeinrichtung (12) und/oder die Aufnahmeeinrichtung (14) den Gegenstand (21) flächig stützen bzw. die Stützung über eine größere Fläche erfolgt.

7. Transporteinrichtung nach einem der vorhergehenden Ansprüche, **dadurch gekennzeichnet, dass** die Aufnahmeeinrichtung (14) anhebbare Rollen und/oder Bänder aufweist, die von unten durch den Boden (17) eines Aufnahmebehälters (16) fahren und den Gegenstand (21) von einer Zuführeinrichtung (12) übernehmen, wobei vorzugsweise durch eine Bewegung der Aufnahmeeinrichtung (14) relativ zu dem Aufnahmebehälter (16) nach unten der Gegenstand (21) darin abgelegt wird.

8. Transporteinrichtung nach einem der vorhergehenden Ansprüche, **dadurch gekennzeichnet, dass** der Aufnahmebehälter (16) durch Transportmittel in die Aufnahmeposition hinein oder von der Aufnahmeposition weg bewegbar ist, wobei vorzugsweise die Transportmittel rotierend sind, insbesondere ein Rollenband (22) aufweisen.

9. Transporteinrichtung nach Anspruch 8, **dadurch gekennzeichnet, dass** die Aufnahmeeinrichtung (14) durch die Transportmittel (22) greift bzw. verläuft bei der Aufnahme eines Gegenstandes (21).

10. Transporteinrichtung nach einem der vorhergehenden Ansprüche, **dadurch gekennzeichnet, dass** Greifmittel vorgesehen sind, insbesondere zum Erfassen eines Aufnahmebehälters (16) und Wegbewegen von der Aufnahmeposition, wobei die Greifmittel vorzugsweise ausgebildet sind um freie Bewegungen im Raum auszuführen, insbesondere einen Gelenkarm aufweisen.

11. Transporteinrichtung nach einem der vorhergehenden Ansprüche, **gekennzeichnet durch** ein Magazin (26) zur Aufbewahrung von Aufnahmebehältern (16), vorzugsweise von mit Gegenständen (21) befüllten Aufnahmebehältern (16), wobei insbesondere das Magazin (26) derart ausgebildet ist, dass die Aufnahmebehälter (16) einzeln und beliebig einbringbar und entnehmbar sind, vorzugsweise unabhängig voneinander und/oder gleichzeitig.

12. Transporteinrichtung nach Anspruch 11, **dadurch gekennzeichnet, dass** die Greifmittel nach Anspruch 10 dem Magazin (26) die Aufnahmebehälter (16) zuführen bzw. darin einbringen.

13. Transporteinrichtung nach Anspruch 11 oder 12, **dadurch gekennzeichnet, dass** dem Magazin (26) zweite Greifmittel für das Ausbringen der Aufnahmebehälter (16) zugeordnet sind, wobei die ersten und zweiten Greifmittel im wesentlichen gleich ausgebildet sind und das Ausbringen der Aufnahmebehälter (16) in umgekehrter Reihenfolge abläuft wie das Einbringen.

14. Transporteinrichtung nach Anspruch 13, **dadurch gekennzeichnet, dass** eine zweite Gegenstands-Aufnahmeeinrichtung (114) und eine zweite Gegenstands-Zuführeinrichtung (112) vorgesehen sind, wobei die zweite Gegenstands-Aufnahmeeinrichtung (114) einen Gegenstand (21) aus einem Aufnahmebehälter (16) heraus der zweiten Gegenstands-Zuführeinrichtung (112) zuführt, wobei vorzugsweise die zweite Gegenstands-Aufnahmeeinrichtung (114) und die zweite Gegenstands-Zuführeinrichtung (112) gleich ausgebildet sind wie die ersten, und insbesondere die Gegenstände (21) anschließend von der zweiten Gegenstands-Zuführeinrichtung (112) weitertransportiert werden.
